# EUROPÄISCHE PATENTSCHRIFT

(11) **EP 3 155 629 B1**
(45) Veröffentlichungstag und Bekanntmachung des Hinweises auf die Patenterteilung: **03.10.2018**
(21) Anmeldenummer: 14753043.0
(22) Anmeldetag: 06.08.2014
(51) Int. Cl.: H01H 85/06, H01L 23/62, H01H 85/02, H01L 25/07

(54) **ELEKTRISCHE EINRICHTUNG MIT EINER ELEKTRISCHEN SICHERUNGSANORDNUNG MIT EINEM METALLSCHAUMSTOFF UND VERFAHREN ZUM UNTERBRECHEN EINES ELEKTRISCHEN STROMES DURCH DIE EINRICHTUNG**
ELECTRICAL DEVICE COMPRISING ELECTRIC SAFETY ARRANGEMENT COMPRISING A METAL FOAM, AND METHOD FOR INTERRUPTING AN ELECTRIC CURRENT USING SAID DEVICE
DISPOSITIF ÉLECTRIQUE COMPRENANT UN ENSEMBLE DE PROTECTION ÉLECTRIQUE MUNI D'UNE MOUSSE MÉTALLIQUE ET PROCÉDÉ D'INTERRUPTION DE COURANT ÉLECTRIQUE AU MOYEN DU DISPOSITIF

(43) Veröffentlichungstag der Anmeldung: 19.04.2017
(73) Patentinhaber: Siemens Aktiengesellschaft, 80333 München (DE)
(72) Erfinder: BREHM, Holger Siegmund, 91052 Erlangen (DE); BÖHM, Matthias, 91564 Neuendettelsau (DE); SCHMITT, Daniel, 92353 Postbauer-Heng (DE)
(86) Internationale Anmeldenummer: PCT/EP2014/066939
(87) Internationale Veröffentlichungsnummer: WO 2016/019995

(56) Entgegenhaltungen:
- EP-A1- 1 403 923
- JP-A- H11 186 299
- JP-A- 2011 192 605
- JP-U- H0 511 275

## Beschreibung

Die Erfindung betrifft eine elektrische Einrichtung mit einer Sicherungsanordnung.

Sicherungsanordnungen sind aus dem Stand der Technik bekannt. Sie dienen zu einer Unterbrechung eines elektrischen Kontaktes im Fehlerfall, wie zum Beispiel bei einem Kurzschluss.

Beispielsweise beschreibt die DE 20 2012 000 571 U1 ein elektrisches Sicherungselement mit einem bei Kurzschluss eine elektrische Verbindung unterbrechenden Schmelzleiter.

Eine Sicherungsanordnung mit einem Metallschaumstoff ist aus der JP 2011 192605 A bekannt.

Die Aufgabe der Erfindung besteht darin, eine elektrische Einrichtung mit einer Sicherungsanordnung vorzuschlagen, die einfach und zuverlässig ist.

Die Aufgabe wird durch eine elektrische Einrichtung gemäß Anspruch 1 und ein Verfahren nach Anspruch 8 gelöst.

Der Metallschaumstoff weist in seinem Inneren Poren auf, so dass sein Volumen gegenüber einem Metall-Vollmaterial vergrößert ist. Diese Eigenschaft kann dazu genutzt werden, eine Trennung eines elektrischen Kontaktes zwischen den beiden Kontaktstücken in einem Bedarfsfall durch eine Volumenverringerung des Metallschaumstoffes zu bewirken. Ein solcher Bedarfsfall ist beispielsweise dann gegeben, wenn die erfindungsgemäße Sicherungsanordnung durch einen vergleichsweise hohen Strom belastet ist. In diesem Falle kann der Metallschaum beispielsweise zum Schmelzen gebracht werden. Da der Metallschaumstoff eine vergleichsweise gute elektrische Leitfähigkeit aufweist, kann bei einer normalen Strombelastung der Strom über die Kontaktstücke und den Metallschaumstoff fließen.

Somit ist eine einfache und zuverlässige Sicherungsanordnung bereitgestellt.

Ein weiterer Vorteil der erfindungsgemäßen elektrischen Einrichtung mit der Sicherungsanordnung ergibt sich daraus, dass der Metallschaumstoff aufgrund seiner Porosität eine höhere Nachgiebigkeit im Vergleich zu einem Vollmaterial besitzt. Dadurch kann der Metallschaumstoff als eine Kontaktfeder beispielsweise fertigungsbedingte Maßtoleranzen der Sicherungsanordnung ausgleichen.

Als Metallschaumstoffe sind beispielsweise Schäume auf der Basis von Stahl, Aluminium oder Titanoxid denkbar. Der Metallschaumstoff kann mittels eines dem Fachmann bekannten pulvermetallurgischen Verfahrens hergestellt sein. Bei diesem Verfahren wird ein Metallpulver (zum Beispiel Aluminiumpulver) mit einem ein Gas abspaltenden Treibmittel (zum Beispiel Titanhydrid) gemischt. Das Pulvergemisch wird anschließend verdichtet und in einem Wärmebehandlungsprozess aufgeschäumt. Denkbar ist die Herstellung des Metallschaumstoffes mittels eines dem Fachmann ebenfalls bekannten schmelzmetallurgischen Verfahrens. Verfahren zur Herstellung eines Metallschaumstoffes sind beispielsweise in der Druckschrift DE 10 2006 031 213 B3 beschrieben. Bei den bekannten Verfahren kann die Anzahl von im Metallschaum entstehenden Poren sowie deren Größe und damit auch die Elastizitätseigenschaften des Metallschaumstoffes nahezu beliebig gewählt werden. Die Elastizitätseigenschaften können dabei beispielsweise durch den Elastizitätsmodul gekennzeichnet sein. Mit steigendem Volumenanteil von Poren sinkt dementsprechend der Elastizitätsmodul des Metallschaumstoffes und damit dessen Steifigkeit.

Gemäß einer bevorzugten Ausführungsform der Erfindung bildet der Metallschaumstoff einen - beispielsweise quaderförmigen - Metallschaumkörper aus. Der Metallschaumkörper ist zwischen den beiden Kontaktstücken angeordnet, so dass bei seinem Schmelzen eine elektrische Isolierung zwischen den Kontaktstücken entsteht. Die elektrische Isolierung kann beispielsweise durch einen Luftspalt zwischen den Kontaktstücken erzielt sein. Der Luftspalt zwischen den Kontaktstücken kann durch eine Volumenverringerung des Metallschaumkörpers entstehen. Die Volumenverringerung tritt insbesondere als eine Folge des Schmelzens des Metallschaumkörpers auf. Sind die beiden Kontaktstücke übereinander angeordnet, so verlagert sich das Metall des schmelzenden Metallschaumkörpers beispielsweise aufgrund der Schwerkraft in Richtung desjenigen der Kontaktstücke, das unten angeordnet ist, wobei ein Luftraum beziehungsweise Luftspalt zwischen den Kontaktstücken entsteht. Dieser Luftspalt kann für einen für eine Unterbrechung des elektrischen Kontaktes ausreichend hohen elektrischen Widerstand beziehungsweise für eine elektrische Isolierung der Kontaktstücke sorgen. Bei einer solchen räumlichen Anordnung der Kontaktstücke zueinander ist auch eine andere, beispielsweise magnetische, Krafteinwirkung auf den schmelzenden Metallschaumkörper denkbar.

Geeigneterweise ist der der Metallschaumkörper Bestandteil eines der Kontaktstücke. Das heißt, dass der Metallschaumkörper mit einem der Kontaktstücke fest verbunden ist, so dass er kein eigenständiges Bauteil darstellt. Auf diese Weise kann der Aufbau der Sicherungsanordnung weiter vereinfacht werden. Insbesondere kann es in diesem Zusammenhang zweckmäßig sein, wenn der Metallschaumkörper innerhalb des Kontaktstückes stromführend ist.

Bevorzugt ist der Metallschaumkörper derart ausgebildet, dass er bei einem einen vorbestimmten Stromschwellenwert überschreitenden Strom durch die Sicherungsanordnung schmilzt. In diesem Fall wird die Sicherungsanordnung insbesondere in einem Kurzschluss-Fall aktiviert. Der Kurzschluss-Strom durch die Sicherungsanordnung verursacht hohe thermische Verluste. Dies wiederum hat einen Anstieg der Temperatur in der Sicherungsanordnung zur Folge. Der Metallschaumstoff des Metallschaumkörpers sollte geeigneterweise derart gewählt sein, dass die Schmelztemperatur des Metallschaumkörpers dem Stromschwellenwert entspricht: Dann schmilzt der Metallschaumkörper bei Strömen oberhalb des Stromschwellenwertes. Auf diese Weise ist eine elektrische Isolierung der Kontakte bei einem den Stromschwellenwert überschreitenden Kurzschluss-Strom erreicht.

Abweichend davon kann das Schmelzen des Metallschaumkörpers auch auf einem anderen Weg erfolgen, zum Beispiel durch eine gezielte Erhitzung des Metallschaumes mittels eines stromdurchflossenen Heizelements.

Die Sicherungsanordnung ist in einer elektrischen Einrichtung mit wenigstens einem Halbleiterelement zwischen den übereinander angeordneten Kontaktstücken eingesetzt, wobei dem Halbleiterelement unter Ausbildung einer elektrischen Reihenschaltung der Metallschaumkörper zugeordnet ist und die Reihenschaltung durch Schmelzen des Metallschaumkörpers auftrennbar ist.

Eine dafür geeignete elektrische Einrichtung ist beispielsweise aus der Druckschrift EP 1 403 923 A1 bekannt. Dort ist ein Halbleitermodul beschrieben, das mehrere in einem Gehäuse parallel angeordnete Halbleiterchips umfasst. Jeder Halbleiterchip ist auf einer unteren leitenden Platte angeordnet und elektrisch mit der unteren und einer oberen leitenden Platte verbunden, die jeweils einen Teil des Gehäuses ausbilden. Zwischen dem Halbleiterchip und der oberen leitenden Platte befindet sich ein Kontaktbolzen, der den elektrischen Kontakt zwischen dem Halbleiterchip und der oberen leitenden Platte herstellt.

In einem Normalbetrieb verteilt sich der durch die elektrische Einrichtung fließender Strom auf die parallel geschalteten Halbleiterchips. Die dabei entstehende Wärme kann durch ein Kühlsystem ausreichend abgeführt werden. Bei einem Fehlerfall kann in einem der Halbleiterchips ein Kurzschluss entstehen, so dass der elektrische Widerstand durch den betroffenen Halbleiterchip wesentlich kleiner als der elektrische Widerstand durch die übrigen Halbleiterchips ist. Dies hat zur Folge, dass der gesamte oder beinahe der gesamte Strom durch die Einrichtung unter Umständen durch den fehlerhaften Halbleiterchip fließt. Diese hohe Stromkonzentration auf der verhältnismäßig kleinen Querschnittfläche des fehlerhaften Halbleiterchips führt zu Übertemperaturen. Diese können zu einer Beschädigung oder Zerstörung der Halbleiterchips oder auch des gesamten Gehäuses und damit zu einem Ausfall der gesamten elektrischen Einrichtung führen.

Die elektrische Reihenschaltung, die durch das eine Kontaktstück, den Metallschaumkörper, das Halbleiterelement und das andere Kontaktstück gebildet ist, ist bei der Verwendung der erfindungsgemäßen Sicherungsanordnung in einer elektrischen Einrichtung dieser Art bevorzugt dadurch auftrennbar, dass beim Schmelzen des Metallschaumkörpers zwischen dem Halbleiterelement und einem der Kontaktstücke ein elektrisch isolierender Spalt entsteht. Auf diese Weise kann erreicht werden, dass der ansonsten durch das fehlerhafte Halbleiterelement fließende Kurzschlussstrom unterbrochen wird und sich auf andere Strompfade, beispielsweise weitere, funktionsfähige Halbleiterelemente, verteilt, wobei die Funktionalität der elektrischen Einrichtung bei geeigneter Bemessung in den anderen Strompfaden gewahrt bleiben kann. Dadurch muss der Fehler in einem der Halbelemente nicht zu einer Beschädigung beziehungsweise zu einem Ausfall der elektrischen Einrichtung führen.

Aufgrund seiner Porosität besitzt der Metallschaumkörper darüber hinaus kontrollierbare elastische Eigenschaften, ähnlich einer Druckfeder. Diese können vorteilhaft dazu genutzt werden, um stets eine optimale Anpresskraft auf das Halbleiterelement zu gewährleisten.

Das Halbleiterelement kann beispielsweise eine Diode oder ein schaltbarer Halbleiter, wie ein Thyristor oder auch ein IGBT (Insulated Gate Bipolar Transistor) sein. Es kann zweckmäßig sein, wenn der Metallschaumkörper in einem Zeitbereich schmilzt, der einer Schaltzeit des schaltbaren Halbleiters entspricht.

Zweckmäßigerweise umfasst die elektrische Einrichtung ferner ein Gehäuse, wobei die beiden Kontaktstücke jeweils einen Teil des Gehäuses ausbilden. Auf diese Weise können mehrere der elektrischen Einrichtungen einfach und kostengünstig, beispielsweise durch aufeinanderstapeln, miteinander elektrisch verbunden werden. Die Anzahl von separaten, aus dem Gehäuse führenden Klemmen beziehungsweise Anschlüssen kann vorteilhaft verringert werden. Die Kontaktstücke dienen in diesem Fall als elektrische Kontakte zu anderen elektrischen Vorrichtungen.

Bevorzugt weist die elektrische Einrichtung mehrere Halbleiterelemente auf, wobei die Halbleiterelemente zwischen den Kontaktstücken parallel angeordnet sind und jedem Halbleiterelement unter Bildung einer Reihenschaltung ein Metallschaumkörper zugeordnet ist, wobei jede Reihenschaltung durch Schmelzen des ihm zugeordneten Metallschaumkörper auftrennbar ist.

Besonders vorteilhaft ist es, wenn die Metallschaumkörper derart ausgebildet sind, dass sie bei einem Kurzschluss durch die Halbleiterelemente zum Schmelzen gebracht werden. Durch eine geeignete Wahl des Metallschaumes kann erreicht werden, dass die Metallschaumkörper bei einem Strom durch die jeweilige Reihenschaltung schmelzen, der einen vorbestimmten Schwellenwert überschreitet. Damit ist in jeder Reihenschaltung eine Schutzeinrichtung bereitgestellt, die die Reihenschaltung bei einem bestimmten Kurzschlussstrom auftrennt. Dies ist insbesondere möglich, wenn der Metallschaumkörper in seiner Form und Zusammensetzung an den Zusammenhang zwischen dem Strom durch die jeweilige Reihenschaltung und der dort entstehenden, durch den Durchlasswiderstand der Reihenschaltung bewirkten Temperatur angepasst ist.

Gemäß einer weiteren Ausführungsform der Erfindung bildet die elektrische Einrichtung einen Spannverband. Das heißt, dass die Kontaktstücke, die Metallschaumkörper und die Halbleiterelemente miteinander mechanisch verspannt sind.

Ferner betrifft die Erfindung ein Verfahren zum Unterbrechen eines elektrischen Stromes durch eine elektrische Sicherungsanordnung mit zwei übereinander angeordneten Kontaktstücken. Eine weitere Aufgabe der Erfindung besteht darin, ein Verfahren dieser Art vorzuschlagen, das einfach und kostengünstig ist.

Die Aufgabe wird durch ein Verfahren nach Anspruch 8 gelöst, bei dem ein zwischen den Kontaktstücken angeordneter Metallschaumstoff bei einem Stromwert oberhalb eines vorbestimmten Stromschwellenwertes zum Schmelzen gebracht wird.

Vorteilhat wird der Metallschaumstoff durch den Strom über die Kontaktstücke zum Schmelzen gebracht. Es ist jedoch auch denkbar, dass der Metallschaumstoff durch eine äußere Einwirkung zum Schmelzen gebracht wird, wenn eine vorgegebene Bedingung eintritt, beispielsweise das Überschreiten/Unterschreiten eines vorbestimmten Schwellwertes durch einen geeigneten, mittels einer Messvorrichtung ermittelten Messwert.

Die Erfindung wird im Folgenden anhand von Figuren 1 - 4 näher erläutert.
- Figur 1: zeigt ein Ausführungsbeispiel einer erfindungsgemäßen Sicherungsanordnung in schematischer Darstellung.
- Figur 2: zeigt ein Ausführungsbeispiel einer erfindungsgemäßen Sicherungsanordnung in einer elektrischen Einrichtung in schematischer Darstellung.
- Figur 3: zeigt ein Ausführungsbeispiel eines Metallschaumkörpers der Sicherungsanordnung aus Figur 2 in schematischer Darstellung.
- Figur 4: zeigt eine weitere schematische Darstellung der elektrischen Einrichtung der Figur 2.

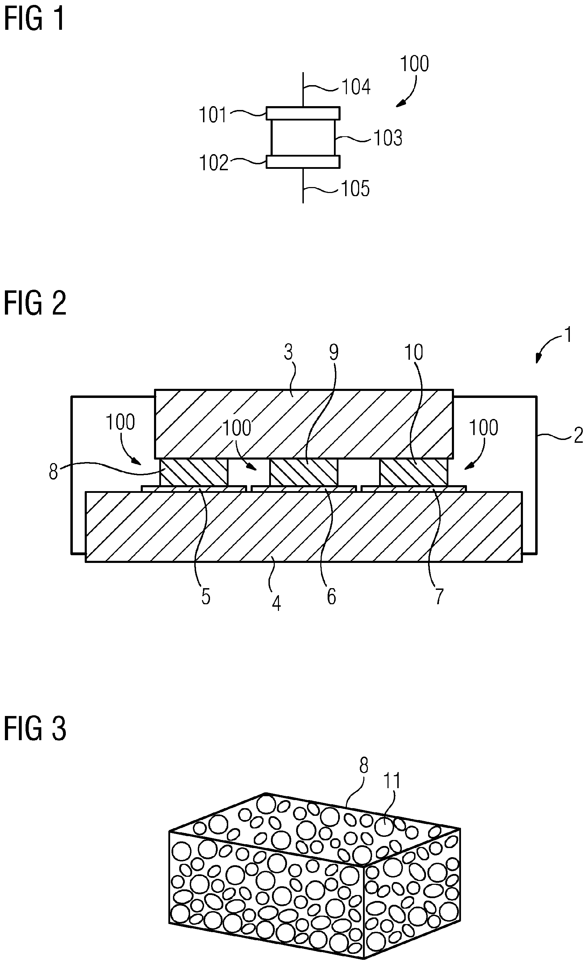

Im Einzelnen ist in Figur 1 eine Skizze einer Ausführungsform einer erfindungsgemäßen Sicherungsanordnung 100 dargestellt. Die Sicherungsanordnung 100 umfasst ein erstes Kontaktstück 101 und ein zweites Kontaktstück 102, die übereinander angeordnet sind. Zwischen den Kontaktstücken 101, 102 befindet sich ein Metallschaumstoff 103. Die Sicherungsanordnung ist Bestandteil eines durch die beiden Stromleitungen 104, 105 angedeuteten Stromkreises. Bei dem Stromkreis kann es sich beispielsweise um ein elektrisches Bauelement handeln.

Während eines Normalbetriebes der Sicherungsanordnung 100 fließt der Strom über die Stromleitung 104, das erste Kontaktstück 101, den Metallschaumstoff 103, das zweite Kontaktstück 102 und die Stromleitung 105. Im Falle eines Kurzschlusses durch die Sicherungsanordnung 100 bewirkt der Kurzschlussstrom insbesondere eine starke Erwärmung der beiden Kontaktstücke 101, 102 und des Metallschaumstoffes 103. Wird ein bestimmter Wert des Kurzschlussstromes überschritten, und damit auch die durch den Widerstand der Sicherungsanordnung 100 der entsprechende Temperaturwert, so schmilzt der Metallschaumstoff 103, wobei sich sein Volumen verringert. Dadurch entsteht zwischen den beiden Kontaktstücken 101, 102 ein isolierender Spalt. Die durch die Kontaktstücke 101, 102 und den Metallschaumstoff gebildete Reihenschaltung wird damit aufgetrennt. Der Stromfluss durch die Sicherungsanordnung 100 wird unterbrochen.

Gemäß einer Variante der Erfindung wird der geschmolzene Metallschaumstoff 103 aus dem Raumbereich zwischen den Kontaktstücken 101, 102 herausgeführt (oder fließt selbständig heraus), so dass der besagte isolierende Spalt entsteht.

In Figur 2 ist der Querschnitt durch eine Ausführungsform einer erfindungsgemäßen elektrischen Sicherungsanordnung 100 in einer Einrichtung 1 dargestellt. In dem in Figur 2 dargestellten Ausführungsbeispiel ist die elektrische Einrichtung 1 durch ein Halbleitermodul realisiert. Das Halbleitermodul 1 weist ein Gehäuse 2 auf, wobei eine obere leitende Platte 3 einen Teil des Gehäuses 2 ausbildet. Eine untere leitende Platte 4 bildet ebenfalls einen Teil des Gehäuses 2 aus, nämlich die Bodenwandung des Gehäuses 2. Die obere leitende Platte 3 und die untere leitende Platte 4 bilden die beiden Kontaktstücke der Sicherungsanordnung 100.

Im Gehäuse 2 sind als Halbleiterchips ausgebildete Halbleiterelemente 5, 6 und 7 parallel nebeneinander angeordnet. Zwischen der unteren leitenden Platte 4 beziehungsweise dem Halbleiterchip 5 und der oberen leitenden Platte 3 ist ein Metallschaumkörper 8 angeordnet. Die obere leitende Platte 3 der Metallschaumkörper 8 der Halbleiterchip 5 sowie die untere leitende Platte 4 bilden eine elektrische Reihenschaltung. Dementsprechend bilden auch die weiteren Halbleiterchips 6 und 7 jeweils mit ihnen zugeordnete Metallschaumkörpern 9 beziehungsweise 10 zwei weitere Reihenschaltungen aus. In einem Normalfall beziehungsweise Betriebszustand, der in Figur 2 dargestellt ist, fließt Strom durch das Halbleitermodul 1, indem er sich auf die drei Reihenschaltungen verteilt. Es ist in diesem Zusammenhang anzumerken, dass weitere Halbleiterchips in dem Halbleitermodul 1 vorgesehen sein können, die jedoch in der in Figur 2 gezeigten Querschnittsdarstellung nicht sichtbar sind.

Figur 3 zeigt den Metallschaumkörper 8 des Ausführungsbeispiels der erfindungsgemäßen Einrichtung aus Figur 2 in schematischer Darstellung. Die Metallschaumkörper 9 und 10 aus Figur 2 sind zum Metallschaumkörper 8 gleichartig aufgebaut. In dem in Figur 3 dargestellten Ausführungsbeispiel ist der Metallschaukörper 8 quaderförmig ausgebildet. Je nach Anwendung beziehungsweise je nach Halbleitergeometrie sind anderen Formen, beispielsweise Zylinder-, Scheiben- oder Kegelformen des Metallschaumkörpers ebenfalls denkbar. Der Metallschaumkörper besteht aus einem Metallschaum. Der Metallschaum entsteht durch ein Aufschäumen eines Metallpulvers durch ein geeignetes Treibmittel. Dadurch ist der Metallschaumkörper 8 insbesondere mit Poren 11 versehen. Die Größe und die Anzahl der Poren 11 bestimmt das Elastizitätsverhalten des Metallschaumkörpers 8. Die elektrischen Eigenschaften des Metallschaumkörpers 8 sind ebenfalls durch die Anzahl, Größe der Poren 11 sowie durch die Form des Metallschaumkörpers 8 beeinflusst.

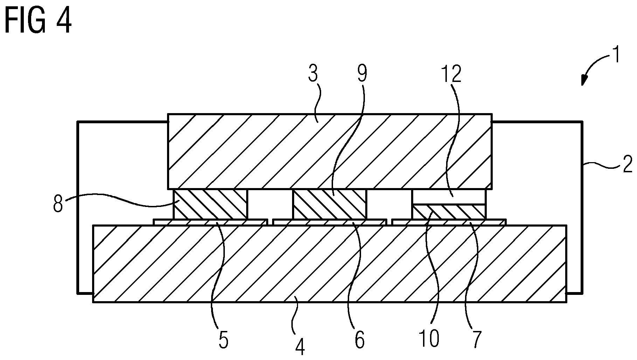

Figur 4 zeigt das Halbleitermodul 1 der Figur 2, bei dem der Metallschaumkörper 10 in einem geschmolzenen Zustand ist. Gleiche und gleichartige Teile in den Figuren 2 bis 4 sind dabei mit gleichen Bezugszeichen versehen. In dem in Figur 4 dargestellten Ausführungsbeispiel wird von einem Fehler im Halbleiterchip 7 ausgegangen, wobei der Ablauf bei Fehlern in den übrigen Halbleiterchips 8 beziehungsweise 9 entsprechend ist. Bei einem derartigen Fehler entsteht ein Kurzschluss im Strompfad durch den Halbleiterchip 7. Die dabei entstehenden hohen Temperaturen führen zu einem Schmelzen des Metallschaumkörpers 10. Der Metallschaumkörper 10 verringert dabei sein Volumen. Das schmelzende Metall des Metallschaumkörpers 10 bildet einen tropfenförmigen Feststoff, der unter der eigenen Gewichtskraft nach unten, das heißt, in Richtung zum Halbleiterchip 7 sinkt. Auf diese Weise entsteht zwischen dem Halbleiterchip 7 und dem der oberen leitenden Platte 3 ein elektrisch isolierender Spalt 12. Die durch die obere leitende Platte 3 dem Metallschaumkörper 10, den Halbleiterchip 7 und die untere leitende Platte 4 gebildete Reihenschaltung wird somit aufgetrennt. Der Stromfluss durch den Halbleiterchip 7 wird unterbrochen. Der Strom durch das Halbleitermodul 1 verteilt sich in diesem Fall auf die beiden anderen Strompfade, die in diesem Fall durch die jeweiligen Reihenschaltungen mit dem Halbleiterchip 5 beziehungsweise dem Halbleiterchip 6 gebildet sind. Die Funktionalität des gesamten Halbleitermoduls 1 kann somit aufrecht erhalten werden, auch in einem Kurzschlussfall im Halbleitermodul 1.

### Bezugszeichenliste

- 1: Halbleitermodul
- 2: Gehäuse
- 3: obere leitende Platte
- 4: untere leitende Platte
- 5, 6, 7: Halbleiterchips
- 8, 9, 10: Metallschaumkörper
- 11: Poren
- 12: Spalt
- 100: Sicherungsanordnung
- 101, 102: Kontaktstück
- 103: Metallschaumstoff
- 104, 105: Stromleitung

## Patentansprüche

1. Elektrische Einrichtung (1) mit einer elektrischen Sicherungsanordnung (100) mit zwei übereinander angeordneten Kontaktstücken (101, 102, 3, 4), zwischen denen sich ein Metallschaumstoff (8, 9, 10, 103) befindet, und mit wenigstens einem Halbleiterelement (5, 6, 7) zwischen den übereinander angeordneten Kontaktstücken (3, 4), wobei der Metallschaumstoff (8, 9, 10, 103) einen derart bemessenen Metallschaumkörper bildet, dass bei seinem Schmelzen eine elektrische Isolierung zwischen den Kontaktstücken (3, 4, 101, 102) entsteht, wobei, dem Halbleiterelement (5 - 7) unter Ausbildung einer elektrischen Reihenschaltung der Metallschaumkörper (8 - 10) zugeordnet ist, wobei die Reihenschaltung durch Schmelzen des Metallschaumkörpers (8 - 10) auftrennbar ist.

2. Elektrische Einrichtung (1) nach Anspruch 1, wobei die elektrische Einrichtung (1) ferner ein Gehäuse (2) umfasst, wobei die beiden Kontaktstücke (3, 4) jeweils einen Teil des Gehäuses ausbilden.

3. Elektrische Einrichtung (1) nach Anspruch 1 oder 2, wobei die Einrichtung (1) mehrere Halbleiterelemente (5 - 7) umfasst, wobei die Halbleiterelemente (5 - 7) zwischen den Kontaktstücken (3, 4) parallel angeordnet sind und jedem Halbleiterelement (5 - 7) unter Bildung einer Reihenschaltung ein Metallschaumkörper (8 - 10) zugeordnet ist, wobei jede Reihenschaltung durch Schmelzen des ihm zugeordneten Metallschaumkörper (8 - 10) auftrennbar ist.

4. Elektrische Einrichtung (1) nach einem der vorangehenden Ansprüche, wobei die Metallschaumkörper (8 - 10) derart ausgebildet sind, dass sie bei einem Kurzschluss durch die Halbleiterelemente (5 - 7) zum Schmelzen gebracht werden.

5. Elektrische Einrichtung (1) nach einem der vorangehenden Ansprüche, wobei die Kontaktstücke (3, 4), die Metallschaumkörper (8 - 10) und die Halbleiterelemente (5 - 7) miteinander in einem Spannverband mechanisch verspannt sind.

6. Elektrische Einrichtung (1) nach Anspruch 1, wobei der Metallschaumkörper Bestandteil eines der Kontaktstücke (3, 4, 101, 102) ist.

7. Elektrische Einrichtung nach Anspruch 1, wobei der Metallschaumkörper (8, 9, 10, 103) derart ausgebildet ist, dass er bei einem vorbestimmten Stromschwellenwert überschreitenden Strom durch die Sicherungsanordnung (1) schmilzt.

8. Verfahren zum Unterbrechen eines elektrischen Stromes durch eine elektrische Einrichtung nach Anspruch 1, bei dem der Metallschaumstoff bei einem Stromwert oberhalb eines vorbestimmten Stromschwellenwertes zum Schmelzen gebracht wird.

9. Verfahren nach Anspruch 8, wobei der Metallschaumstoff durch den Strom über die Kontaktstücke (3, 4) zum Schmelzen gebracht wird.

## Claims

1. Electrical device (1) comprising an electrical safety arrangement (100) with two contact pieces (101, 102, 3, 4) arranged one on top of the other, between which a metal foam (8, 9, 10, 103) is located, and having at least one semiconductor component (5, 6, 7) between the two contact pieces (3, 4) arranged one on top of the other, wherein the metal foam (8, 9, 10, 103) forms an appropriate metal foam body such that, upon the melting thereof, electrical isolation is effected between the contact pieces (3, 4, 101, 102),wherein
a metal foam body (8 - 10) is associated with a respective semiconductor component (5 - 7) to form an electrical series circuit, wherein the series circuit is separable by the melting of the metal foam body (8 - 10).

2. Electrical device (1) according to Claim 1, wherein the electrical device (1) also comprises a housing (2), wherein the contact pieces (3, 4) each form one part of the housing respectively.

3. Electrical device (1) according to Claim 1 or 2, wherein the device (1) incorporates a plurality of semiconductor components (5 - 7), wherein the semiconductor components (5 - 7) are arranged in parallel between the contact pieces (3, 4), and a series circuit is formed by the association of a metal foam body (8 - 10) with each semiconductor component (5 - 7), wherein each series circuit is separable by the melting of its associated metal foam body (8 - 10).

4. Electrical device (1) according to one of the preceding claims, wherein the metal foam bodies (8 - 10) are configured such that the melting thereof is caused in the event of a short-circuit on the semiconductor components (5 - 7).

5. Electrical device (1) according to one of the preceding claims, wherein the contact pieces (3, 4), the metal foam bodies (8 - 10) and the semiconductor components (5 - 7) are mechanically compressed in a pressure assembly.

6. Electrical device (1) according to Claim 1, wherein the metal foam body is a constituent element of one of the contact pieces (3, 4, 101, 102).

7. Electrical device according to Claim 1, wherein the metal foam body (8, 9, 10, 103) is configured such that it melts upon the passage of a current through the safety arrangement (1) which exceeds a predefined threshold current value.

8. Method for the interruption of an electric current in an electrical device according to Claim 1, wherein the metal foam is caused to melt by a current value which exceeds a predefined threshold current value.

9. Method according to Claim 8, wherein the metal foam is melted by the passage of current via the contact pieces (3, 4).

## Revendications

1. Dispositif (1) électrique, comprenant un agencement (100) de court-circuit électrique ayant deux pièces (101, 102, 3, 4) de contact superposées entre lesquelles se trouve une mousse (8, 9, 10, 103) métallique et au moins un élément (5, 6, 7) à semi-conducteur entre les pièces (3, 4) de contact superposées, la mousse (8, 9, 10, 103) métallique formant un corps en mousse métallique de dimension telle que sa fusion crée un isolant électrique entre les pièces (3, 4, 101, 102) de contact,
dans lequel
le corps (8 à 10) en mousse métallique est associé à l'élément (5 à 7) à semi-conducteur en formant un montage électrique en série, le montage en série pouvant être coupé par fusion du corps (8 à 10) de mousse métallique.

2. Dispositif (1) électrique suivant la revendication 1, dans lequel le dispositif (1) électrique comprend, en outre, un boîtier (2), les deux pièces (3, 4) de contact formant chacune une partie du boîtier.

3. Dispositif (1) électrique suivant la revendication 1 ou 2, dans lequel le dispositif (1) comprend plusieurs éléments (5 à 7) à semi-conducteur, les éléments (5 à 7) à semi-conducteur étant montés en parallèle entre les pièces (3, 4) de contact et un corps (8 à 10) de mousse métallique est associé à chaque élément (5 à 7) à semi-conducteur, en formant un montage en série, dans lequel chaque montage en série peut être coupé par fusion du corps (8 à 10) de mousse métallique, qui lui est associé.

4. Dispositif (1) électrique suivant l'une des revendications précédentes, dans lequel les corps (8 à 10) de mousse métallique sont constitués de manière à être portés à la fusion s'il se produit un court-circuit dans les éléments (5 à 7) à semi-conducteur.

5. Dispositif (1) électrique suivant l'une des revendications précédentes, dans lequel les pièces (3, 4) de contact, les corps (8 à 10) de mousse métallique et les éléments (5 à 7) à semi-conducteur sont serrés mécaniquement ensemble en un système serré.

6. Dispositif (1) électrique suivant la revendication 1, dans lequel le corps de mousse métallique fait partie de l'une des pièces (3, 4, 101, 102) de contact.

7. Dispositif (1) électrique suivant la revendication 1, dans lequel le corps (8, 9, 10, 103) de mousse métallique est constitué de manière à fondre s'il passe, dans l'agencement (1) de court-circuit, un courant dépassant une valeur de seuil définie à l'avance.

8. Procédé d'interruption d'un courant électrique dans un dispositif électrique suivant la revendication 1, dans lequel on porte à la fusion la mousse métallique à une valeur du courant supérieure à une valeur de seuil définie à l'avance.

9. Procédé suivant la revendication 8, dans lequel on porte à la fusion la mousse métallique par le courant passant par les pièces (3, 4) de contact.
